# EUROPEAN PATENT SPECIFICATION

(11) **EP 0 455 407 B1**
(45) Date of publication and mention of the grant of the patent: **26.07.1995**
(21) Application number: 91303680.2
(22) Date of filing: 24.04.1991
(51) Int. Cl.: B29C 67/20, H01B 3/00, B29K 27/18, B29K 105/16

(54) **Insulating material and production thereof**
Isolationsmaterial und dessen Herstellung
Matériau d'isolation et production du même

(30) Priority: 01.05.1990 JP 116596/90
(43) Date of publication of application: 06.11.1991
(73) Proprietor: JUNKOSHA CO. LTD., Setagaya-ku Tokyo 156 (JP)
(72) Inventor: Sato, Yoshiaki, Hannoh, Saitama (JP)
(74) Representative: McCallum, William Potter

(56) References cited:
- EP-A- 0 304 699
- EP-A- 0 348 712
- DE-A- 1 180 298
- DE-A- 2 354 711
- GB-A- 2 121 350
- GB-A- 2 209 167
- US-A- 4 187 390
- DATABASE WPIL Week 8735, Derwent Publications Ltd., London, GB; AN 81-82346D

## Description

The present invention relates to an insulating material which has improved electrical properties owing to microballoons incorporated therein, and also to a process for producing the same.

Among conventional common insulating materials are polytetrafluoroethylene (PTFE) resin and polyethylene resin which have low-dielectric constants. They are often used in porous form for their improvement in electrical properties. Unfortunately, a porous PTFE resin structure cannot be produced by conventional physical or chemical processes using inert gas or blowing agents which are commonly applied to other fluoroplastics and ordinary thermoplastic resins, because a PTFE resin has an extremely high melt viscosity. This necessitates the use of special processes, such as, for example, mixing a PTFE resin with a substance removably by extraction or dissolution, forming the mixture under pressure, and subsequently removing the substance; or adding a liquid lubricant to a PTFE resin powder, extruding and forming the mixture by rolling or other shear force, removing the liquid lubricant, and drawing and sintering the moulded item; or drawing an unsintered moulded item of PTFE resin in a liquid (such as halogenated hydrocarbon, petroleum hydrocarbon, alcohol, or ketone) which sets a PTFE resin, and subsequently sintering the moulded item.

The processes mentioned above all give rise to open-cell porous PTFE structures, which are liable to change partly into closed, cell structures because their pores are easily collapsed on the application of compressive force. This tendency is undesirable particularly in the case where the porosity is increased to lower the dielectric constant. If such a porous PTFE resin is moulded into tape or sheet for use as an insulating material for electric wires and printed-circuit boards, the resulting insulating material is difficult to handle because of its unstable electrical properties (such as dielectric constant).

In order to overcome the above-mentioned shortcomings of prior art technologies the present inventors previously proposed a process for producing a porous closed-cell PTFE structure. This process consists of mixing a PTFE resin with glass or silica microballoons containing an inert gas (such as nitrogen and carbon dioxide) sealed therein, and forming the mixture by rolling (or any other means that exerts a shear force) such that the PTFE resin matrix constitutes fibers which enclose the microballoons, permitting the gas in the microballoons to substantially remain as voids, as described in Japanese Patent Publication No. 25769/1989 or in its corresponding UK Patent Application GB-A-2 209 167. The microballoons are present in high concentrations (50 to 95 wt %) relative to the PTFE (5 to 50 wt %).

This technology solved many problems associated with the porous open-cell PTFE structures but did not address the disadvantage that the dielectric constant does not decrease in proportion to the amount of microballoons added.

An object of the present invention is to obviate or mitigate the aforesaid disadvantages.

JP-A-62 037 482 discloses a method of producing a conductive porous material from an electrically insulating porous material, such as PTFE, polyethylene or polypropylene by packing with an electrically conductive material, such as metal or carbon. In a disclosed example, a porous sheet of PTFE is impregnated with an isopropyl alcohol solution containing 20 g/l carbon black while ultrasonic waves were applied to the solution. The impregnated porous sheet is dried by heating.

According to the present invention there is provided an insulating material which comprises a low-dielectric open-celled porous polymeric base material and a plurality of low-dielectric rigid microballoons which are located in the pores of said low-dielectric porous polymeric base material for prevention against pore collapse, characterised in that the amount of microballoons present is between 0.1 to 20 wt % of the total weight of the insulating material.

According to a further aspect of the present invention there is provided a process for producing an insulating material which comprises dipping a low-dielectric open-celled porous polymeric base material in an ultrasonically stirred liquid in which are dispersed a plurality of low-dielectric hard microballoons, thereby causing the low-dielectric hard microballoons to enter the pores of the low-dielectric open-celled porous polymeric base material, and subsequently applying heat, thereby causing the low-dielectric porous polymeric base material to shrink slightly so that the low-dielectric hard microballoons are fixed in the pores.

An embodiment of the present invention will now be described, by way of example, with reference to the accompanying representations in which:-
Fig. 1 is an electron micrograph taken prior to heating and showing the porous structure of insulating material of the present invention;
Fig. 2 is an electron micrograph taken after heating and showing the slightly shrunk porous structure of the same insulating material as Fig. 1; and
Fig. 3 is an electron micrograph showing the porous structure of conventional porous insulating material containing microballoons.

The insulating material of the present invention contains a large number of low-dielectric hard microballoons which are held in the pores of low-dielectric porous polymeric base material for prevention against pore collapse. These microballoons are those of hard insulating material such as glass, particularly glass containing more than 80% silicon dioxide, and have a particle diameter from 0.1 to 50 um, which is selected according to the diameter of pores in the base material. They contain a gas such as nitrogen and carbon dioxide sealed therein, so that they have a low-dielectric constant, low loss tangent, and low specific gravity. The amount of the microballoons in the insulating material is not specifically limited; but it is usually in the range of 0.1 to 20 wt% preferably 1 to 10 wt%.

The low-dielectric, ie. dielectric constant below 2, porous polymeric base material, which has an open-celled fine porous structure, may be produced from a fluorocarbon resin or polyolefin resin by any known method such as leaching, emulsion, irradiation, sintering, and stretching or expanding. According to the stretching and expanding method, drawing of the polymeric base material gives rise to fibers and nodes interconnected by fibrils which form fine open cells. The fibrils vary in diameter and length and the nodes vary in size and number depending on the drawing and sintering conditions. The low-dielectric open-celled porous polymeric base material may have a properly selected pore diameter and porosity.

The insulating material of the present invention is constructed such that the polymeric base material holds in its pores low-dielectric rigid microballoons of a size smaller than the pore sizes, eg. 20 »m or less, which effectively prevent the pores from being collapsed by compressive force. Moreover, the insulating material has a low-dielectric constant and stable electrical properties because the pores are not completely filled by the microballoons.

The method of the present invention utilizes ultrasonic vibration to disperse the microballoons into the pores of the base material, so that the base material is exempt from compressive force in the manufacturing step. Therefore, the insulating material of the present invention has good electrical properties based on the original low-dielectric constant of the base material which is enhanced by the microballoons filled therein.

### Examples

The invention will be described in more detail with reference to the following examples, which are not intended to restrict the scope of the invention.

A sample of the insulating material of the present invention was prepared in the following manner from a low-dielectric porous polymeric base material which is an open-celled porous PTFE resin sheet having a porosity of 75.4%, a thickness of 100 »m, and a dielectric constant of 1.20, formed in known manner by stretching, and low-dielectric rigid microballoons which are glass microballoons (made by Emerson & Cumming Co Ltd) having a dielectric constant of 1.20 and a particle diameter smaller than 15 »m. The microballoons were dispersed in acetone held in a metal container placed on an ultrasonic vibrator (50 kHz frequency and 30 W output). In the ultrasonically stirred dispersion was dipped the open-celled porous PTFE sheet for 5 minutes. This dipping operation was repeated with the sheet turned up side down. After the dipping operation, the PTFE sheet was dried and then heated at 200°C for 1 minute without restraint so that the sheet shrank slightly and fixed the microballoons in the pores.

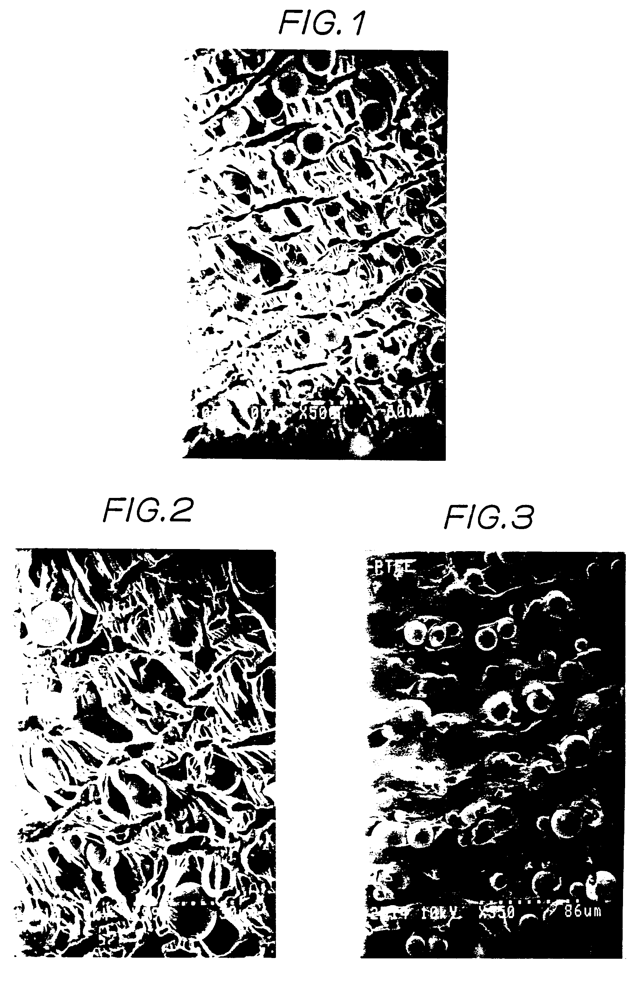

Figs. 1 and 2 are electron micrographs taken respectively before and after the polymeric base material was treated with microballoons. It is noted that the microballoons are not broken in the pores of the base material but are fixed by the fibrillated PTFE. It is also noted that there is liberal space around the microballoons so that the insulating material retains a high porosity. The sheet had a dielectric constant as low as 1.25 owning to the glass microballoons filled in the pores which accounted for 10 wt%. This sheet was tested for compression resistance by measuring the dielectric constant after compression under a load of 10 kg/cm² for 30 minutes. The results are shown in Table 1.

In Comparative Example 1, an insulating material in sheet form was prepared by rolling from a PTFE resin powder and glass microballoons mixed in the same ratio as in Example 1 mentioned above. (This insulating material is that which the present inventors proposed in the above-mentioned Japanese Patent Publication No. 25769/1989). It has the internal structure as shown in Fig. 3. In Comparative Example 2, the same test as in Example 1 was performed on an open-celled porous PTFE sheet which contains no glass microballoons but has almost the same dielectric constant as that of the insulating material in Example 1. The results are shown in Table 1.

**TABLE 1**

| | EXAMPLE 1 | | COMPARATIVE EXAMPLE 1 | | COMPARATIVE EXAMPLE 2 | |
|---|---|---|---|---|---|---|
| | Before Compression | After Compression | Before Compression | After Compression | Before Compression | After Compression |
| Dielectric Constant | 1.25 | 1.27 | 1.60 | 1.70 | 1.20 | 1.45 |

It is noted from Table 1 that the porous insulating material of the present invention prevents its pores from being collapsed by compressive force and hence keeps its original electrical properties almost unchanged owing to the low-dielectric hard microballoons filled in the pores. In addition, it has a lower dielectric constant than those produced by conventional methods. Therefore, it can be used in the form of film or sheet for insulation of electric wires, cables, and printed-circuit boards. Its low-dielectric constant and high stability to external force contribute to an improvement in its performance.

## Claims

1. An insulating material which comprises a low-dielectric open-celled porous polymeric base material and a plurality of low-dielectric rigid microballoons which are located in the pores of said low-dielectric porous polymeric base material for prevention against pore collapse, characterised in that the amount of microballoons present is between 0.1 to 20 wt % of the total weight of the insulating material.

2. Insulating material as claimed in claim 1 wherein the porous polymeric base material is porous polytetrafluoroethylene (PTFE).

3. Insulating material as claimed in claim 2 wherein the porous polytetrafluoroethylene is porous expanded polytetrafluoroethylene having a structure of nodes interconnected by fibrils.

4. Insulating material as claimed in claim 1, 2 or 3 wherein the amount of microballoons present is between 0.1 to 10 wt% of the total weight of the insulating material.

5. A process for producing an insulating material which comprises dipping a low-dielectric open-celled porous polymeric base material in an ultrasonically stirred liquid in which are dispersed a plurality of low-dielectric hard microballoons, thereby causing the low-dielectric hard microballoons to enter the pores of the low-dielectric open-celled porous polymeric base material, and subsequently applying heat, thereby causing the low-dielectric porous polymeric base material to shrink slightly so that the low-dielectric hard microballoons are fixed in the pores.

## Patentansprüche

1. Ein Isolationsmaterial, das ein niedrigdielektrisches, offenzelliges, poröses polymeres Basismaterial und eine Mehrzahl von niedrigdielektrischen, festen Mikroballonen aufweist, die in den Poren des genannten niedrigdielektrischen porösen polymeren Basismaterials zur Verhinderung von Poren-Kollaps angeordnet sind,
**dadurch gekennzeichnet,**
daß die Menge der vorhandenen Mikroballone zwischen 0,1 bis 20 Gew.-% in Bezug auf das Gesamtgewicht des Isolationsmaterials beträgt.

2. Isolationsmaterial, wie in Anspruch 1 beansprucht, bei welchem das poröse polymere Basismaterial poröses Polytetrafluorethylen (PTFE) ist.

3. Isolationsmaterial wie in Anspruch 2 beansprucht, bei welchem das poröse Polytetrafluorethylen ein poröses, expandiertes Polytetrafluorethylen mit einer Struktur von untereinander durch Fibrillen verbundenen Knoten ist.

4. Isolationsmaterial, wie in Anspruch 1, 2 oder 3 beansprucht, bei welchen die Menge der vorhandenen Mikroballone zwischen 0,1 bis 10 Gew.-% in Bezug auf das Gesamtgewicht des Isolationsmaterials beträgt.

5. Ein Verfahren zum Herstellen eines Isolationsmaterials, mit den Schritten: Eintauchen eines niedrigdielektrischen, offenzelligen, porösen polymeren Basismaterials in eine ultraschall-gerührte Flüssigkeit, in welche eine Mehrzahl von niedrigdielektrischen harten Mikroballonen dispergiert wird, wodurch die niedrigdielektrischen harten Mikroballone dazu veranlaßt werden, in Poren des niedrigdielektrischen, offenzelligen, porösen polymeren Basismaterials einzudringen, und nachfolgendes Anwenden von Wärme, wodurch das niedrigdielektrische poröse polymere Basismaterial dazu veranlaßt wird, leicht zu schrumpfen, so daß die niedrigdielektrischen harten Mikroballone in den Poren fixiert werden.

## Revendications

1. Matériau d'isolation qui comprend une matière de base polymérique poreuse à alvéoles ouvertes faiblement diélectrique et une pluralité de microballons rigides faiblement diélectriques qui sont situés dans les pores de ladite matière de base polymérique poreuse faiblement diélectrique afin de prévenir l'effondrement des pores, caractérisé en ce que la quantité de microballons présente est comprise entre 0,1 et 20% en poids par rapport au poids total du matériau d'isolation.

2. Matériau d'isolation selon la revendication 1 dans lequel la matière de base polymérique poreuse est du polytétrafluoréthylène (PTFE) poreux.

3. Matériau d'isolation selon la revendication 2 dans lequel le polytétrafluoréthylène poreux est du polytétrafluoréthylène poreux expansé ayant une structure en noeuds interconnectés par des fibrilles.

4. Matériau d'isolation selon la revendication 1, 2 ou 3 dans lequel la quantité de microballons présente est comprise entre 0,1 et 10% en poids par rapport au poids total du matériau d'isolation.

5. Procédé de production d'un matériau d'isolation qui comprend l'immersion d'une matière de base polymérique poreuse à alvéoles ouvertes faiblement diélectrique dans un liquide soumis à l'agitation par ultrasons dans lequel est dispersée une pluralité de microballons durs faiblement diélectriques, provoquant ainsi la pénétration des microballons durs faiblement diélectriques dans les pores de la matière de base polymérique poreuse à alvéoles ouvertes faiblement diélectrique, et l'application subséquente de chaleur, causant ainsi un léger rétrécissement de la matière de base polymérique poreuse faiblement diélectrique de manière à fixer les microballons durs faiblement diélectriques dans les pores.
